(19) Europäisches Patentamt
European Patent Office
Office européen des brevets

(11) EP 2 164 301 A2

(12) EUROPEAN PATENT APPLICATION

(43) Date of publication:
17.03.2010 Bulletin 2010/11

(51) Int Cl.:
H05B 33/08 (2006.01)

(21) Application number: 09169697.1

(22) Date of filing: 08.09.2009

(84) Designated Contracting States:
AT BE BG CH CY CZ DE DK EE ES FI FR GB GR
HR HU IE IS IT LI LT LU LV MC MK MT NL NO PL
PT RO SE SI SK SM TR
Designated Extension States:
AL BA RS

(30) Priority: 11.09.2008 TW 97134803

(71) Applicant: Advanced Optoelectronic Technology
Inc.
No.13, Gongye 5th Road
Hsinchu Industrial Park
Hukou Township
Hsinchu County 303 (TW)

(72) Inventors:
• Tseng, Wen Liang
303, Hsinchu County (TW)
• Lin, Hsin Chiang
303, Hsinchu County (TW)

(74) Representative: 2K Patentanwälte Blasberg
Kewitz & Reichel
Partnerschaft
Corneliusstraße 18
60325 Frankfurt am Main (DE)

(54) **Method and system for configuring high CRI LED**

(57) A method and a system for configuring a high CRI LED is provided in this invention, by using an algorithm to compute which of at least two phosphors that can be mixed with the LED. A mixed-emitting spectrum can provide a high CRI white light at a predetermined color temperature. The proposed method for configuring high CRI LED comprises the steps of:

calculating a standard spectrum, wherein the standard spectrum is a visible spectrum radiated from a blackbody with a first color temperature;

providing an emission spectrum of an LED; an emission spectrum of a first fluorescent powder, and an emission spectrum of a second fluorescent powder; and

adjusting the first fluorescent powder and the second fluorescent powder based on the standard spectrum to generate a first mixed-emitting spectrum.

Calculate a standard spectrum — 41

Provide a emission spectrum of a LED, a emission spectrum of a first fluorescent powder, and a emission spectrum of a second fluorescent powder — 42

43 — Adjust the proportional relation of first fluorescent powder and the second fluorescent powder based on the standard spectrum to generate a first mixed-emitting spectrum similar to the standard spectrum

44 — Calculate the CRI of the first mixed-emitting spectrum in standard color plates

45 — Determine a standard color plate with the lowest CRI and to adjust the proportional relation of the first fluorescent powder and the second fluorescent powder to generate a second mixed-emitting spectrum

FIG. 4

EP 2 164 301 A2

**Description**

**BACKGROUND OF THE INVENTION**

(A) Field of the Invention

The present invention relates to high CRI (color rendering index) LEDs, and more particularly, to a method and a system for configuring high CRI LEDs.

(B) Description of the Related Art

Light emitting diodes (LED) are electrical devices capable of transforming electric energy into optical energy having characteristics similar to diodes. An LED with direct current generates stable illumination, while an LED with alternating current generates flashes with a frequency dependent on the frequency of the alternating current. When an external voltage is applied to an LED, electrons and electron holes may pair within the LED and accordingly transform the energy into the lights emitted.

Most LEDs are a composition of III-arsenide, III-phosphides, III-nitride, or II-VI semiconductor compounds. Different materials generate photons carrying different energy. Accordingly, different kinds of wave, spectrum, and color of light can be controlled by altering the composition of such materials. Using such material control, the optoelectronic industry has produced LEDs with different wavelengths ranging from infrared rays to blue rays, and violet-ray and ultraviolet-ray LEDs are currently under development. The aforesaid LEDs are monochrome or single-frequency LEDs. White LEDs, unlike the aforesaid LEDs, are characterized by a frequency distribution within the visible spectrum range. Currently, a white LEDs may be a multi-chips type LED or a single-chip LED.

A multi-chip LED is a composition of red, green, and blue LED chips and generates white light by mixing these three colors through a lens. The multi-chip LED has the advantage of high luminous efficiency and flexibility for adjusting colors, but it requires greater effort to design circuits for each individual chip and presents difficulty in controlling the lifespan of the LED. Part of the difficulty is attributed to the decay rate and the lifespan differences among such three chips.

Single-chip LED types use three methods to generate white light. The first method, a typical one, directs a blue ray generated by an blue light LED toward yellow fluorescent powder and therefore stimulates the yellow fluorescent powder to generate white light. Adjusting the intensity of the blue ray and the proportional relations of the yellow fluorescent powder may control the CIE value of an LED, as long as an appropriate wavelength of blue ray is selected for the yellow fluorescent powder. This type of white LED, however, has a low General Color Rendering Index (Ra) due to the low intensity in the red color. If such LED is adopted as an auxiliary light source for digital cameras, the picture taken, especially the subject's face, generally appears pale. Therefore, the industry is currently endeavored to develop a white LED with high CRI.

The second method, to offset the low red intensity, directs a blue ray generated by an LED toward green and red fluorescent powders or directs the blue ray toward green and yellow fluorescent powders so as to improve CRI value of a white light LED. The third method directs an ultraviolet ray generated by an LED toward green, red, and blue fluorescent powders to generate white LED.

As disclosed by US 2007/0194695 A1, a white light LED may be produced by a blue ray LED accompanied by inorganic orange fluorescent powders and inorganic green fluorescent powders. The proportional relation between the inorganic orange fluorescent powder and the inorganic green fluorescent powder may be adjusted to absorb wavelengths with the range of the wavelengths similar to actual white light. For example, a blue ray LED can be adopted to generate white lights by stimulating an inorganic orange fluorescent powder ($Zn(Se_{0.1}, S_{0.9}):Cu$) and an inorganic green fluorescent powder (Eu-activated $\beta$-sialon).

As disclosed by Taiwan patent publication number 1263360, the stimulated light source can emit light with a wavelength between 258nm and 490nm, and fluorescent powders are arranged around the stimulated light source to absorb rays radiated from the light source. The fluorescent powders can be green, magenta, red, or blue fluorescent powders wherein the materials for green and magenta fluorescent powders are selected from a group composed of $(Me_{1-x-y}Eu_xRe)_8Mg_{z(}SiO_4)_mCl_n$, the material of red fluorescent powders is selected from a group composed of $(Me_{1-x-y}Eu_xRe_y)S$, the material of blue fluorescent powder is selected from a group composed of $(Ca_{1-x-y}Eu_xRe_y)_5$ $(PO_4)_3Cl:Eu^{2+}Gd^{2+}$, and the aforesaid compositions meet the following conditions: $0<x\leqq0.8$, $0<y\leqq2.0$, $0<z\leqq1.0$, $1.0\leqq m\leqq6.0$, $0.1\leqq n\leqq3.0$. Me is selected from a group composed of Ca, Sr, and Ba. Re is selected from a group composed of Pr, Rb, Dy, Sm, Ho, Y, Er, Eu, Tm, Yb, Lu, Gd, Mg, and Mn. A violet ray with a wavelength 385nm may be directed to stimulate the appropriate mixture of the aforesaid fluorescent powders to create a white light with a better CRI with 4 wavelengths.

As mentioned above, red fluorescent powders or two or more kinds of fluorescent powders may be adopted to improve the CRI of an LED. When combining two fluorescent powders to generate a mixed-emitting light source with a specific CIE value, three factors must be adjusted simultaneously. The factors include the proportional relation of the two fluorescent powders and the intensity of the light source. Therefore trial-and-error experimentation is inevitable for adjusting the factors. Taiwan patent publication number 1263360 mentioned the problem when it described using four kinds of fluorescent powders for a specific CIE. The process and the time consumed to generate a specific CIE generally increase exponentially. If additional conditions, such as different color-temperature conditions, are considered, a white light LED with a better CRI shall require even more time to determine an optimized fluorescent powder proportional relation.

As all kinds of fluorescent powders are being developed, it becomes harder to adjust two kinds, more kinds, or different kinds of fluorescent powders to produce an LED with high CRI. Accordingly, the time required for LED development becomes longer and the challenge for preparing a product for marketing is greater.

## SUMMARY OF THE INVENTION

Compared with the prior arts, the present invention provides a method for configuring high CRI LED to meet the industry's demand. The first step is to calculate a standard spectrum which is a visible spectrum radiated from a blackbody with a first color temperature. The next step provides an emission spectrum of an LED, an emission spectrum of a first fluorescent powder, and an emission spectrum of a second fluorescent powder, and adjusts the first fluorescent powder and the second fluorescent powder based on the standard spectrum to generate a first mixed-emitting spectrum similar to the standard spectrum.

The step of calculating the standard spectrum is based on the Planck Formula. The first mixed-emitting spectrum is generated by stimulating the LED, the first fluorescent powder, and the second fluorescent powder. The next step is to calculate the CRI of the first mixed-emitting spectrum in standard color plates and to determine a standard color plate with the lowest CRI. Based on the information of the color plate with the lowest CRI, the first fluorescent powder and the second fluorescent powder are adjusted to generate a second mixed-emitting spectrum.

One embodiment of the present invention provides a method for configuring high CRI LED. The first step of the method is to calculate a standard spectrum, wherein the standard spectrum is a visible spectrum radiated from a blackbody with a first color temperature. The second step is to provide an emission spectrum of an LED, an emission spectrum of a first fluorescent powder, and an emission spectrum of a second fluorescent powder. Based on the standard spectrum provided, the first fluorescent powder and the second fluorescent powder are adjusted to generate a first mixed-emitting spectrum. A method is provided to calculate the CRI of the first mixed-emitting spectrum in standard color plates, to determine a standard color plate with the lowest CRI, and based on such color plate to adjust the first fluorescent powder and the second fluorescent powder to generate a second mixed-emitting spectrum.

The present invention also provides a system for configuring high CRI LED, and the system comprises means for calculating a standard spectrum, wherein the standard spectrum is a visible spectrum radiated from a blackbody with a first color temperature; means for obtaining the emission spectrum of an LED, an emission spectrum of a first fluorescent powder, and an emission spectrum of a second fluorescent powder; means for adjusting the first fluorescent powder and the second fluorescent powder based on the standard spectrum to obtain a first mixed-emitting spectrum; means for calculating the CRI of the first mixed-emitting spectrum in standard color plates; means for determining a standard color plate with the lowest CRI; and means for adjusting the proportional relations of the first fluorescent powder and the second fluorescent powder to generate a second mixed-emitting spectrum.

Another embodiment of the present invention provides a system for configuring high CRI LED. A first database is adopted to store an emission spectrum of an LED, an emission spectrum of a first fluorescent powder, and an emission spectrum of a second fluorescent powder. A second database is adopted to store a reflection spectrum of standard color plates. The system provides a blending unit to calculate a mixed-emitting spectrum of the LED, the first fluorescent powder, and the second fluorescent powder. Such mixed-emitting spectrums are stored in the first database. The mixed-emitting spectrum is the first mixed-emitting spectrum. The system further provides a standard color-temperature spectrum generator to generate a visible spectrum radiated from a blackbody with a first color temperature, and a spectrum comparison unit to compare the first mixed-emitting spectrum with the standard spectrum generated by the standard-color temperature-spectrum generator. A reflection spectrum generating unit of a standard color plate is included to read the reflection spectrum of standard color plates stored in the second database, and to generate standard color plate reflection spectrums of the first mixed-emitting spectrum and standard color plate reflection spectrums of the standard spectrums. A color plate spectrum comparison unit is adopted to compare standard color plate reflection spectrums of the first mixed-emitting spectrum with standard color plate reflection spectrums of the standard spectrums.

The method, measurement, and system are based on the Planck Formula to calculate the standard spectrum. The first mixed-emitting spectrum is generated by stimulating the LED, the first fluorescent powder, and the second fluorescent powder. The first fluorescent powder can be $CaSc_2O_4:Ce$, $(MgCaSrBa)_2SiO_4:Eu$, $Ca_3SC_2Si_3O_{12}Ce$, $(Ca_{1.47}Mg_{1.5}Ce_{0.03})(SC_{1.5}Y_{0.5})Si_3Ol_2$, or $(Ca_{2.97}Ce_{0.03})Sc_2(Si,Ge)_3O_{12}$. The second fluorescent powder can be $CaAlSiN_3:Eu$, $(CaEu)AlSiN_3$, $(SrCa)AlSiN_3:Eu$, or $SrGa_2S_4:Eu$. The present invention can further include a third fluorescent powder and its emission spectrum.

The present invention further includes a method of calculating proportional relations between multiple fluorescent powders for configuring high CRI LED including the steps of: adjusting the proportional relations between multiple fluorescent powders such that a spectrum of the mixed color of an LED is similar to a spectrum radiated from a blackbody with a first color temperature, determining a color plate with the lowest CRI among reflection spectrums of standard color plates, and adjusting the proportional relations between multiple fluorescent powders based on the color plate with the lowest CRI.

The present invention also provides a method of utilizing two steps of approximation to determine the proportional relations between various fluorescent powders for configuring high CRI LED. The first step is to adjust the proportional relations of various fluorescent powders for a radiation close to blackbody radiation, and the second step is to adjust the proportional relations of various fluorescent powders based on a color plate with the lowest CRI.

One purpose of the present invention is to utilize software calculation to allocate the proportional relations of various fluorescent powders efficiently. Time required for trial and error is thus reduced.

## BRIEF DESCRIPTION OF THE DRAWINGS

FIG. 1 illustrates a CIE chromaticity diagram;

FIG. 2 illustrates a distribution of the blackbody radiation under different color temperatures in the CIE chromaticity diagram;

FIG. 3 illustrates a flow chart for calculating the proportional relations of multiple fluorescent powders to configure an LED with high CRI;

FIG. 4 illustrates a flow chart for a method of configuring an LED with high CRI;

FIG. 5 illustrates a block diagram for a system to configure an LED with high CRI;

FIG. 6 illustrates a block diagram for a method of configuring a white light LED with high CRI;

FIG. 7 illustrates a block diagram for configuring a white light LED with high CRI based on the similarity comparison between emission spectrums;

FIG. 8 illustrates mixed-emitting spectrums of the LED chips and of two kinds of fluorescent powders;

FIG. 9 illustrates a comparison of a mixed-emitting spectrum with a visible spectrum radiated from a blackbody with a predetermined color temperature;

FIG. 10 illustrates a block diagram of a system for configuring a white light LED with high CRI based on CRI comparison; and

FIG. 11 illustrates a block diagram of a system for configuring a white light LED with high CRI.

## DETAILED DESCRIPTION OF THE INVENTION

The present invention is related to an LED with high CRI and its manufacture. For a better understanding of the present invention, the steps and the composition are disclosed in the following discussion. The scope of present invention is not limited to the technology used in the LED industry or used by those skilled in LED manufacture. Ordinary skills are not disclosed so that unnecessary limitations on the present invention are avoided. The disclosure of the preferred embodiments is to help those skilled in the art to understand the present invention. Accordingly, the scope of the present invention shall be not limited to embodiments disclosed but shall be properly determined by the claims as set forth below.

One of the key elements to generate a white light is fluorescent material. As soon as the fluorescent body is stimulated by photon, electrical fields, or electron rays, the electrons within the fluorescent body jump to excited states. While the electrons in the excited state are generally unstable, the electrons may return to ground state radiatively or non-radiatively through the process of relaxation. The radiative relaxation generates photons or rays, and the non-radiative relaxation causes the lattice of the fluorescent to vibrate and thus generate heat. If the energy is released in an electromagnetic wave manner, photons are generated. If the wavelength of the rays is within visible range, human beings can identify such rays. The wavelengths of the rays are relevant to the electron transitions between the energy states or the energy levels.

The fluorescent powder is mainly composed of host lattices (H). For example, ZnS is the host lattice material of $ZnS:Cu^{2+}$. By adding or doping some other foreign ions in the host lattice, the foreign ions become ready to be stimulated and are known as the "activator" or the emission center of the fluorescent lattice. Some fluorescent material may be doped by a second kind of foreign ion, and is known as a sensitizer or co-activator. If the host lattice and the activator are properly controlled, fluorescent powders may generate various kinds of wavelengths. The host lattices of fluorescent powders available on the market are Sulfides, Oxides, Oxysulfides, Nitrides, Oxynitrides, Garnet, and Silicates.

People generally perceive white light to appear the same as sunlight. White light, however, is a continuous spectrum ranging from 400nm to 700nm. It can be categorized by visible colors of red, orange, yellow, green, blue, indigo, and violet. While a normal LED generates only monochrome lights, a white light LED requires a mixture of at least two complementary colors. One of the technical concerns of white light manufacturing is the LED's ability to display the colors of an object precisely. Such display is known as Color Rendering. Better Color Rendering allows the LED color to be closer to the actual color or the natural color. The Color Rendering Index (CRI) of a white light LED is relevant to the chips of LED, fluorescent powder, color temperature, and the material used.

Color Temperature is measured by a method of heating up a metal with a characteristic similar to a blackbody, and the color emitted from the metal varies as the temperature changes. The temperature affect on the color of the light source is defined as the color temperature of such light source. For example, when an iron is heated, the first color to appear is red, next is orange, followed by blue and white. Researchers verify the relation between color and temperature by a series of spectrums. The wavelength is represented on the x axis, and the radiation flux is indicated on the y axis. The radiation flux of an iron at different temperatures can be represented by a diagrammatic curve because the y axis may reflect different radiation fluxes based on different wavelengths. For example, when the iron turns red, the radiation flux of red outweighs other colors. At this point the diagrammatic curve has a peak, and as the temperature rises, the peak moves toward a shorter wavelength and the radiation flux of all wavelengths increases. When the iron's temperature is close to 4200K, the peak of the radiation flux is close to a wavelength of red colors, and the iron appears as a red object. As the temperature rises higher, the peak of the radiation flux move toward a shorter wavelength close to that of orange, and the iron appears as an orange object. When the temperature approaches 5800K, the peak of the radiation flux is close to yellow-green.

The color temperature and blackbody radiation are estimated using Kelvin temperature. When a blackbody can absorb all energy without any loss and is capable of transforming the energy to the form of light, the blackbody's color may vary when the temperature is changed. For example, the color of a blackbody with a temperature around 500-550°C is dark red, but the color becomes yellow when the temperature goes up to 1050-1150°C . Accordingly, the color of a light source is relevant to the heat or energy absorbed by the blackbody, and the color temperature may be represented by Kelvin temperature. The blackbody's color can be white if the blackbody emits photons with all visible wavelengths. The tungsten lamp, a typical example from daily use, is close to such a blackbody. Based on the aforesaid relation between color and a blackbody's temperature, any color temperature of a light source may be represented by the temperature of blackbody and by a corresponding point in Planck's Locus of a chromaticity diagram. The curve of a blackbody shall change with temperature. Accordingly, any blackbody with the same temperature shall have the same curve.

Natural light source varies with color, time, weather, observer, season, and geographical location, and therefore is inconvenient for color definitions. The Commission International de l'Eclariagre, abbreviated as CIE, therefore defines various standard light sources similar to the natural light source.

The same object may have a different color when illuminated by one light source and by a reference light source. The general Color Rendering Index, RA, represents such color differences. The value of the CRI is determined by comparing the color of 8 standard color samples or standard color plates as defined by DIN6169 when the samples or plates are illuminated by the reference light source with the color of the same samples or plates illuminated by a light source to be determined. There are 14 standard color samples or 14 standard color plates for the international rule. The more apparent the difference is, the lower the CRI, and the greater the color distortion. The CRI of the sun is defined as 100, the CRI of a high voltage sodium lamp is 23, and the CRI of fluorescent lamps is 60-90.

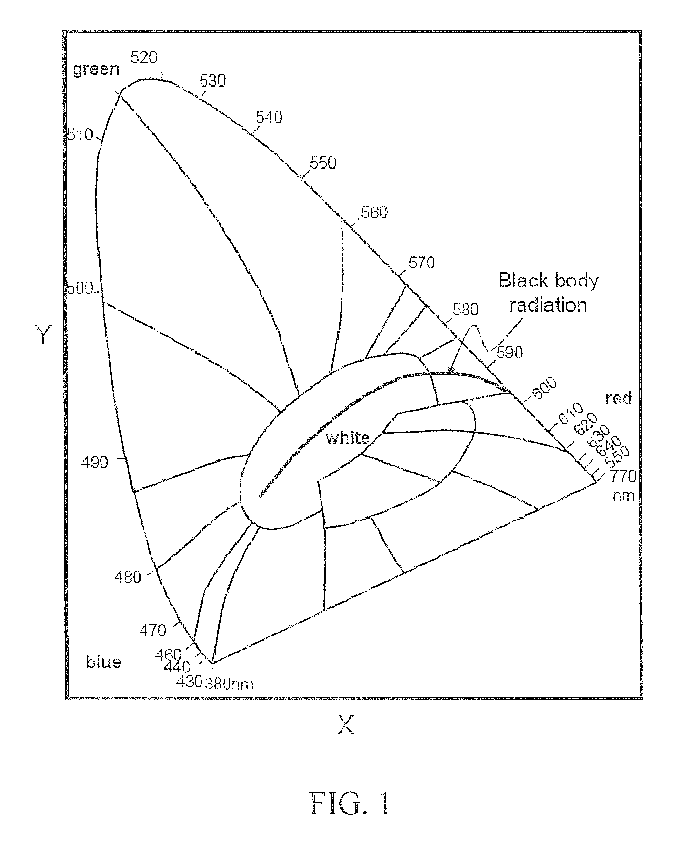

CIE further defines a 1931 standard observer based on a mathematical model for eyesight and an experiment for color comparison. Such norm is defined by three curves to represent a color comparison function, and is also known as CIE 1931 standard color matching function. As shown in FIG. 1, x represents the measured red color, while y represents the measured green of the CIE 1931 chromaticity diagram. The wavelengths within the horseshoe-shaped boundary represent all visible colors, and the wavelengths on the horseshoe boundary represent saturated monochrome wavelengths. The system utilizes x, y, and z to represent red, green and blue; each point in the diagram represents one color.

While the diagram shows x and y only, z can be derived by the equation x+y+z=1. The point in the middle of the coordinate (0.33,0.33) represents white light. The edge of each color space represents spectrum colors, and the number on the boundary represents the wavelengths of spectrum colors. The boundary represents the maximum saturation of each spectrum color, and its contour represents all visible colors. Since all monochrome wavelengths are located on the tongue-shaped curve, such curve is a locus of monochrome and the numbers marked besides it are the wavelengths corresponding to each monochrome wavelength (or known as spectrum color). The natural and actual colors are within the boundary of the curves.

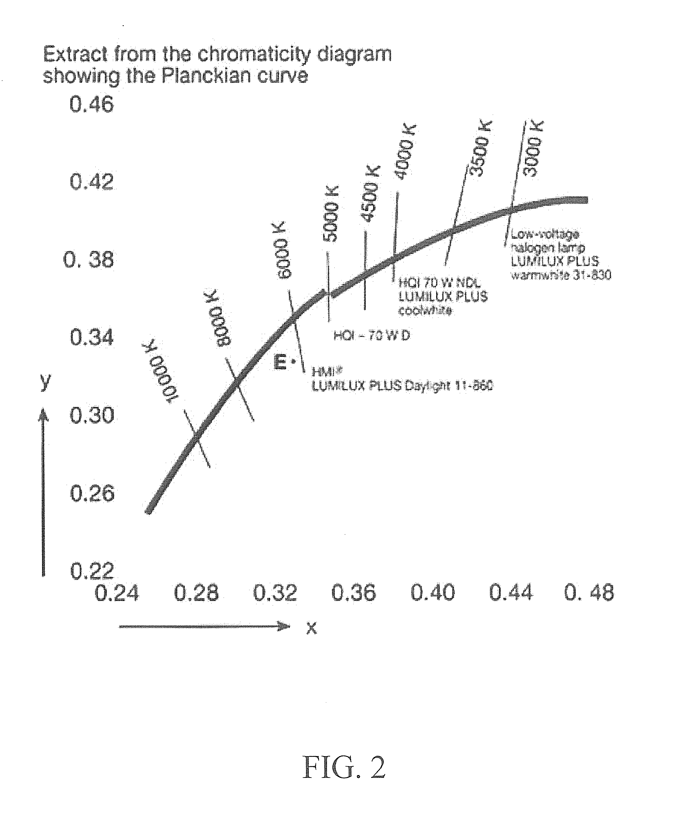

FIG. 2 shows a color distribution of a blackbody with different color temperature in the chromaticity diagram. The concept of Planck's Locus is derived from blackbody radiation. The German physicist Kirchhoff proposed the law of radiation and indicated that the absorption rate and radiation rate of an object are relevant to the characteristics of its surface. A blackbody is defined as having the capability to absorb radiation of any frequency under any temperature. Certainly, no perfect blackbody can exist. In theory, a cavity with a tiny hole is close to a blackbody because once a ray is emitted into the cavity through such tiny hole, the ray has a minimal chance of escaping from the cavity thus making the cavity similar to the blackbody that absorbs all radiations. If the cavity is heated to certain temperature, the spectrum observed from the cavity is close to the spectrum observed from a blackbody.

In 1879, J. Stefan found that the total energy (E) of blackbody radiation is proportional to temperature (T) to the power of 4 and devised the formula $E = aT^4$, or the Stefan-Boltzmann law.

In 1893, Wien discovered that wavelength is proportional to temperature and came up with the Wien displacement law: $T\lambda_{max}$=constant. In 1896, Wien further proposed a formula based on experiments: pv=αv3exp(βv/T), wherein pv is radiant energy density, ν is frequency, T is Kelvin temperature, and α and β are constants.

In 1900, J.W. Rayleigh and J.H. Jeans used classic mechanics and statistical physics to derive a blackbody radiation formula, the Rayleigh-Jeans Law:

$$\rho_\nu = \frac{8\pi\nu^3}{c^3}\kappa_B T$$

wherein c is the velocity of light, and K is Boltzmann's constant.

This formula matches the experimental results when the frequency is low. However, as ν→∞ and ρv→∞, the formula apparently fails which is known as ultraviolet catastrophe.

After more detailed experiments, Wien apparently deviated from the experimental data in the long wavelength portion. In 1900, the German physicist M. Plank came up with a formula match the experimental data as follows:

$$\rho_\lambda = \frac{8\pi hc}{\lambda^5}\frac{1}{\exp(hc/\lambda\kappa_B T)-1} \quad \text{or} \quad \rho_\nu = \frac{8\pi h\nu^3}{c^3}\frac{1}{\exp(h\nu/\kappa_B T)-1}$$

,wherein h is Planck's constant, or $6.626\times10^{-34}$ J•s. Planck's theory has successfully explained the Rayleigh-Jeans Law, the Wien displacement law, and the Stefan-Boltzmann law.

The manufacturing of a white light LED with high CRI is time consuming and costly due to the cross-tests adopted and the various factors affecting the CRI value. Factors include different color temperature, the chips of an LED, and the fluorescent powders. The present invention based on Plank's law and blackbody radiation discloses a method and system for configuring a white light LED with high CRI by adjusting multiple fluorescent powders.

The present invention is relevant to a method of utilizing two steps of approximation to determine the proportional relations of various fluorescent powders for configuring high CRI LED. The first step is to adjust the proportional relations of various fluorescent powders for a radiation close to blackbody radiation. The second step is to adjust the proportional relations of various fluorescent powders based on a color plate with the lowest CRI.

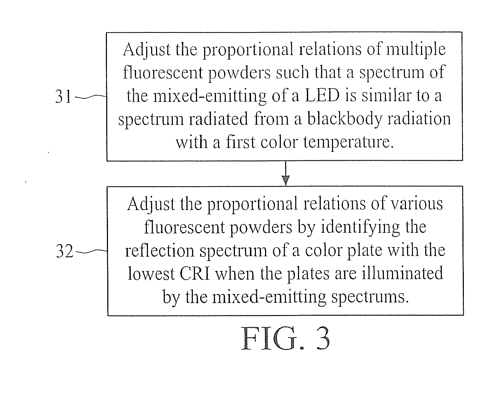

As shown in FIG. 3, the present invention discloses a method for calculating multiple fluorescent powders for configuring a high CRI LED. The first step 31 is to adjust the proportional relations of multiple fluorescent powders such that a spectrum of the mixed color of an LED is similar to a spectrum radiated from a blackbody with a first color temperature. Such LED can be an ultraviolet LED, violet LED, or blue LED. Multiple fluorescent powders can be comprised of two or more kinds of fluorescent powders, and the use of each fluorescent powder is based on the color of light to be generated by the LED. For example, ultraviolet or violet LED requires three kinds of fluorescent LED to generate a mixed-emitting white light. A blue LED, however, requires two kinds of fluorescent powder for configuring a white light LED with high CRI. The second step (32) is to adjust the proportional relations of various fluorescent powders by identifying the reflection spectrum of a color plate with the lowest CRI when the plates are emitted by the mixed-emitting spectrums. Generally, when a mixed-emitting spectrum is emitted onto the 14 standard color plates, the reflection spectrum of one of the standard color plates will be relatively lower. Based on the information collected from such low reflection spectrum color plate, the proportional relation of the fluorescent powder may be adjusted to improve the CRI of the reflection spectrum of the color plate with the lowest CRI.

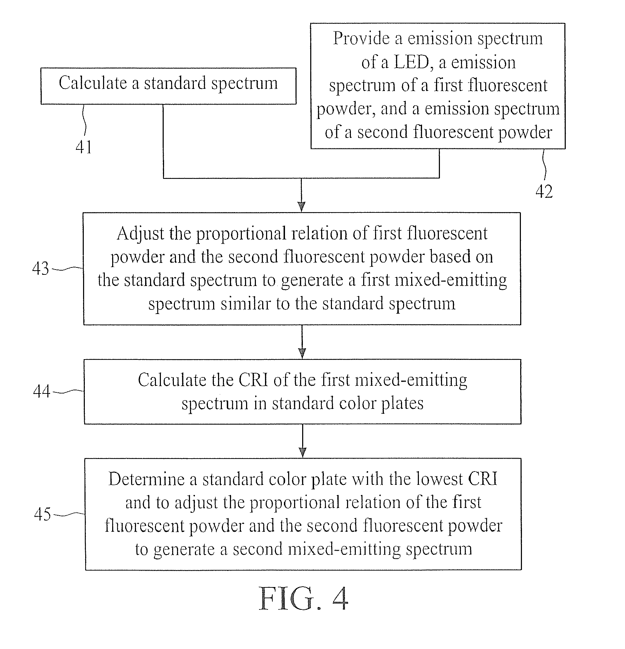

As shown in FIG. 3, the present invention discloses a method for configuring a high CRI LED. A more detailed process is disclosed in FIG. 4. The first step (41) calculates a standard spectrum, wherein the standard spectrum is a visible spectrum radiated from a blackbody with a first color temperature. The second step (42) provides an emission spectrum of an LED, an emission spectrum of a first fluorescent powder, and an emission spectrum of a second fluorescent powder. The third step (43) adjusts the proportional relation of the first fluorescent powder and the second fluorescent powder based on the standard spectrum to generate a first mixed-emitting spectrum similar to the standard spectrum. The fourth step (44) calculates the CRI of the first mixed-emitting spectrum in standard color plates. The fifth step (45) determines a standard color plate with the lowest CRI. and adjusts the first fluorescent powder and the second fluorescent powder to generate a second mixed-emitting spectrum. Generally, when a mixed-emitting spectrum is emitted onto the 14 standard color plates, the reflection spectrum of one of the standard color plates will be relatively lower. Based on the information collected from such low reflection spectrum color plate, the proportional relation of the fluorescent powders may be adjusted to improve the CRI of the reflection spectrum of the standard color plate with the lowest CRI. In FIG. 4, the present invention discloses two kinds of fluorescent powder to implement the embodiment. However, three kinds, four kinds, or five kinds of fluorescent powder may be used to achieve the same outcome.

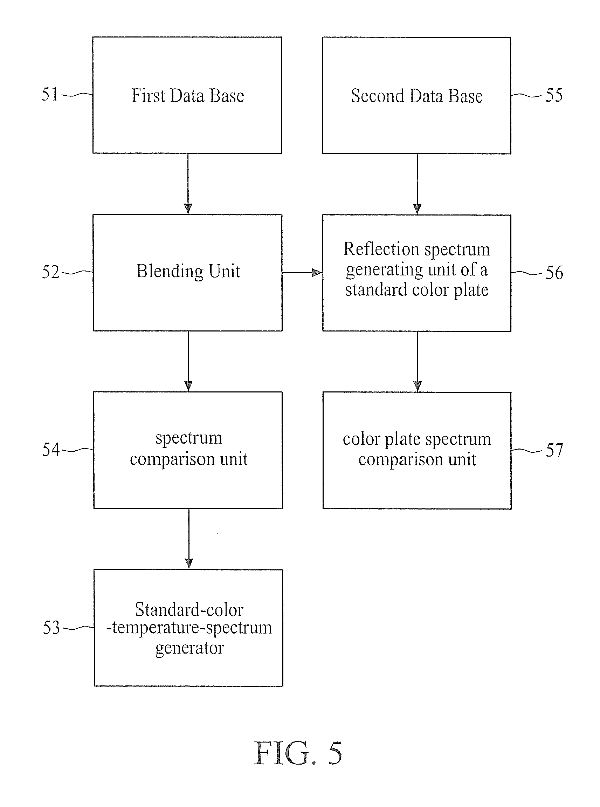

According to the procedure adopted in Fig. 4, another embodiment of the present invention provides a system for configuring a high CRI LED. FIG. 5 discloses a first data base (51) to store an emission spectrum of an LED, an emission spectrum of a first fluorescent powder, and an emission spectrum of a second fluorescent powder. FIG. 5 also discloses a blending unit (52) to calculate a mixed-emitting spectrum of the LED, of the first fluorescent powder, and of the second fluorescent powder stored in the first database (51). The mixed-emitting spectrum described above is a first mixed-emitting spectrum. FIG. 5 further discloses a standard-color temperature-spectrum generator (53) to generate a visible spectrum radiated from a blackbody with a first color temperature, and a spectrum comparison unit (54) to compare the first mixed-emitting spectrum with the standard spectrum generated by the standard-color temperature-spectrum generator (53). When the spectrum comparison unit (54) finds the similarity between the first mixed-emitting spectrum and the visible spectrum radiated from a blackbody with a first color temperature, the data of first mixed-emitting spectrum is transmitted to the next step. If the spectrum comparison unit (54) finds dissimilarity instead, a blending unit (52) may continue to recalculate a first mixed-emitting spectrum until a similarity is found.

FIG. 5 discloses a second database (55) to store a reflection spectrum of standard color plates. FIG. 5 further discloses a reflection spectrum generating unit (56) of a standard color plate to read the reflection spectrum of standard color plates stored in the second database (55), and to generate standard color plate reflection spectrums of the first mixed-emitting spectrum and standard color plate reflection spectrums of the standard spectrums. A color plate spectrum comparison unit (57) is adopted to compare the standard color plate reflection spectrums of the first mixed-emitting spectrum with standard color plate reflection spectrums of the standard spectrums. When the outcome of the CRI comparison is similar and the number is close to predetermined number such as 95 or 97, the first mixed-emitting spectrum is a white light with high CRI. When one or two of the color plates after the comparison come out with a CRI lower than average or lower than a predetermined value, the process returns to the blending unit (52) and re-calculates the first mixed-emitting spectrum until the comparison process implemented by the color plate spectrum comparison unit (57) is finished.

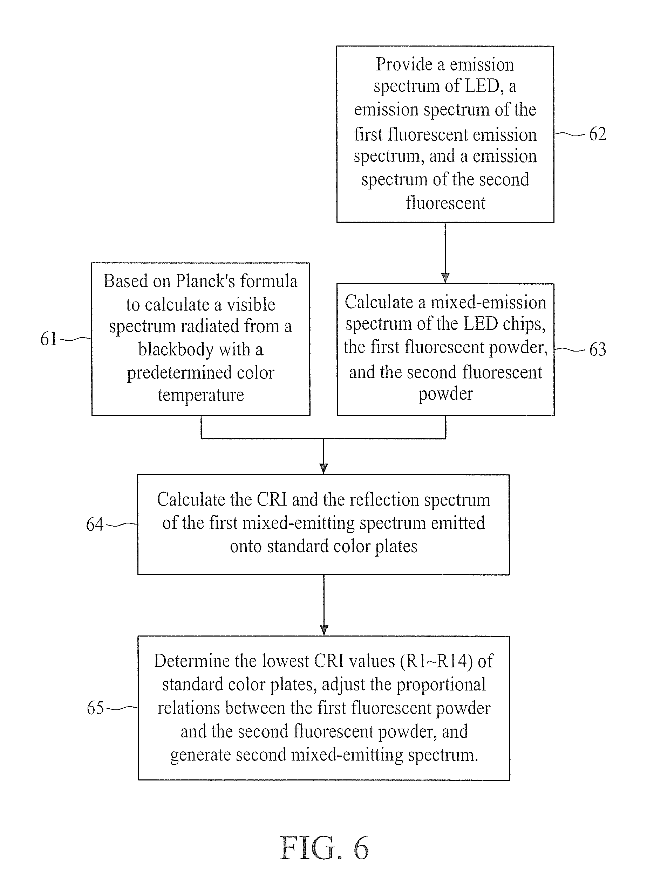

The following figures disclose a preferred embodiment of the present invention. FIG. 6 discloses a process for configuring a high CRI white light LED. In the first step (61), Planck's formula:

$$\rho_\lambda = \frac{8\pi hc}{\lambda^5} \frac{1}{\exp\left(hc / \lambda \kappa_B T\right) - 1} \quad (1)$$

is adopted to calculate a visible spectrum radiated from a blackbody with a predetermined color temperature. Rayleigh-Jeans, Stefan-Boltzmann, or Wien's formulas, however, may be used for a simplified method for calculating spectrums of blackbody radiation. Based on Planck's formula, a visible spectrum of a blackbody may be derived from a particular color temperature (ranging from 2500K to 8000K). In this step, such visible spectrum of the color temperature of the blackbody is represented by $T_a(\lambda)$.

The second step (62) provides an emission spectrum of LED, an emission spectrum of the first fluorescent emission spectrum, and an emission spectrum of the second fluorescent. When two kinds of fluorescent powder are used, all kinds of emission spectrums of the fluorescent powders shall be provided. In this step, $L(\lambda)$ represents the

emission spectrum of the LED, P1($\lambda$) represents the emission spectrum of the first fluorescent powder, and P2($\lambda$) represents the emission spectrum of the second fluorescent powder.

The third step (63) adjusts the proportional relation of the fluorescent powders in accordance with the visible spectrum calculated in the first step and then calculates a mixed-emitting spectrum of the mixture of LED chips, the first fluorescent powder, and the second fluorescent powder. The calculation is illustrated below:

$$C_a(\lambda) = a \times L(\lambda + \Delta\lambda) + b \times P1(\lambda + \Delta\lambda) + c \times P2(\lambda + \Delta\lambda) \text{ and seek a set of } (a,b,c)$$

$$\text{that has the minimum value of } \sum_{\lambda} |T_a(\lambda) - C_a(\lambda)|^2 \qquad (2)$$

The mixed-emitting spectrum is represented by $C_a(\lambda)$, the intensity of the LED chips is represented by a, the proportional relation of the first fluorescent powder is represented by b, and the proportional relation of the second fluorescent powder is represented by c.

The above-described embodiments of the present invention are intended to be illustrative only. Those skilled in the art may utilize other functions or formulas to calculate the proportional relation of each fluorescent powder and obtain a mixed-emitting spectrum $C_a(\lambda)$ as the first mixed-emitting spectrum.

The fourth step (64) calculates the CRI and the reflection spectrum of the first mixed-emitting spectrum emitted onto standard color plates. The purpose is to compare the first spectrum with a mixed-emitting emission spectrum, or with the visible spectrum radiated from a blackbody with a predetermined color temperature among the reflection spectrum of the 14 standard color plates. The method of comparison may be illustrated by the function below:

First, the reflection spectrums of the 14 color plates emitted by visible spectrums of the predetermined color temperature are calculated:

$$T_a(\lambda) \text{ (reflection spectrums of the 14 color plates )} = T_a(N_0) colorcheck(\lambda) \qquad (3)$$

$N_0$ represents the serial number of each color plate, and colorcheck($\lambda$) represents the reflection spectrum of each color plate.

Simultaneously, the reflection spectrum of 14 color plates of the first color-mixed spectrum or of the mixed-emitting spectrum $C_a(\lambda)$ is calculated.

$$C_a(\lambda) = C_a(N_0) colorcheck(\lambda) \qquad (4)$$

Each reflection spectrum of the 14 standard color plates is compared by utilizing function (3) and function (4). In the present step, a formula similar to function (2) is applied for the calculation of each color plate as below:

$$\sum_{\lambda} |T_a(N_0) colorcheck(\lambda) - C_a(N_0) colorcheck(\lambda)|^2 \qquad (5)$$

The fifth step (65) determines the maximum difference between the CRI values (R1 -R14) and returns to step 2 (62) to adjust the proportional relations between the first fluorescent powder and the second fluorescent powder, i.e. adjusting (b,c), or to select alternative fluorescent powders. A second mixed-emitting spectrum can be found to improve the R value with the maximum differences. In step (65), the purpose is to provide a serial number for the color plate that deviates the most from others based on function (5). The adjustment/reselection of the fluorescent powder is thus based on the information collected from the color plate of such serial number. The loop of calculation continues until the differences of the CRI value (R1 - R14) is within an acceptable range or the variation of the differences is within an acceptable range.

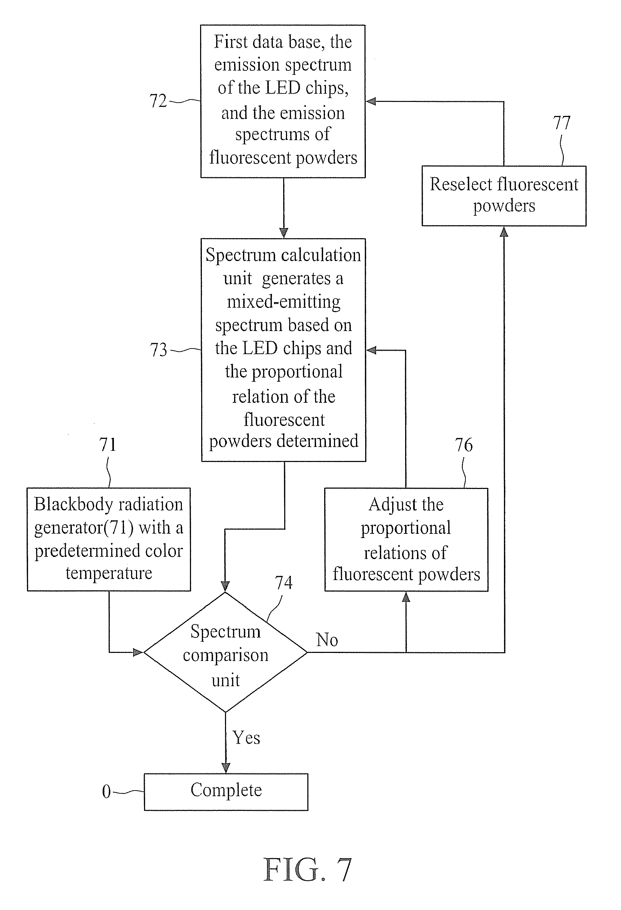

As the procedure shown in FIG. 6, the present invention provides a diagram for configuring a white light LED with high CRI. As shown in FIG. 7, a blackbody radiation generator (71) with a predetermined color temperature may generate a visible spectrum radiated from a blackbody with a predetermined color temperature. The color temperature ranges from 1500K to 8000K. A first database (72) is adopted to store an emission spectrum of an LED and emission spectrums of fluorescent powders. The emission range of an LED with UVA light is 365nm - 380nm, while the emission range for an LED with violet light is 380nm - 420nm and an LED with blue light is 420nm - 470nm. The wavelength of an emission generated by a fluorescent powder is between 480 and 580nm. The fluorescent powder can be a composition of compounds with silicates or oxides thereof, such as:

$CaSc_2O_4$:Ce(516nm),

$(MgCaSrBa)_2SiO_4$:Eu (525nm),

$Ca_3Sc_2Si_3O_{12}$:Ce(455-507nm),

$(Ca_{1.47}Mg_{1.5}Ce_{0.03})(Sc_{1.5}Y_{0.5})Si_3Ol_2$(455nm),or

$(Ca_{2.97}Ce_{0.03})SC_2(Si,Ge)_3O_{12}$.

The fluorescent powder can be a composition of compounds with nitrides or sulfides and with emission wavelength between 600nm and 650nm such as:

$CaAlSiN_3$:Eu(650nm),

$(CaEu)AlSiN_3$(648nm),

$(SrCa)AlSiN_3$:Eu(630nm), or

$SrGa_2S_4$:Eu(645nm).

Those skilled in the art may utilize other kinds of fluorescent powder to implement the present invention, such as a compound with garnetite or with nitrogen oxides.

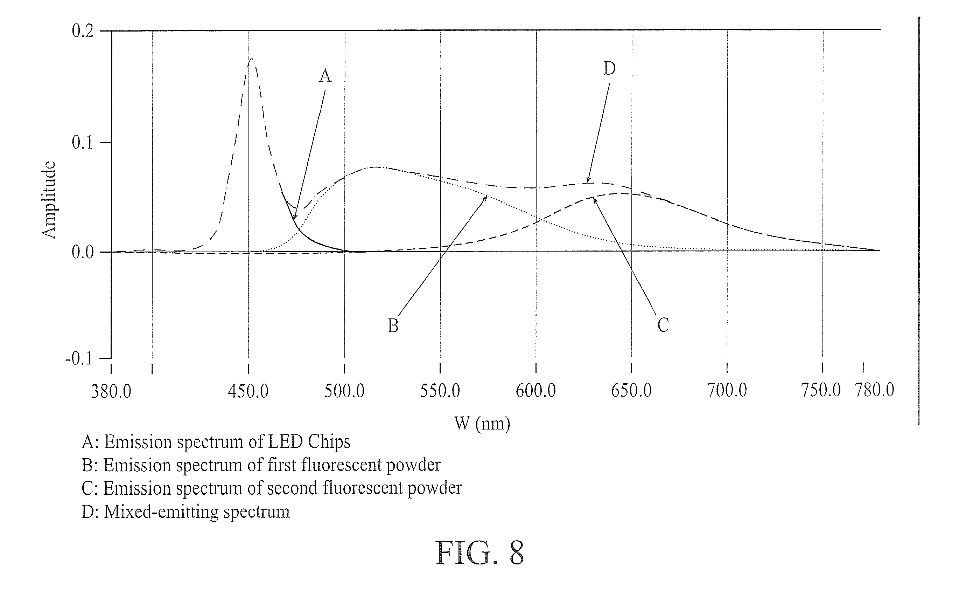

A spectrum calculation unit (73) derives from the first database (72) the emission spectrum of the LED chips and the emission spectrums of two kinds of fluorescent powders. Based on the proportional relation of the fluorescent powders determined, the spectrum calculation unit (73) generates a mixed-emitting spectrum as shown in FIG. 8. Curve A represents the emission spectrum of the LED chips, Curve B and Curve C represent the emission spectrums of the fluorescent powders, and Curve D represents the mixed-emitting spectrum after a mixture.

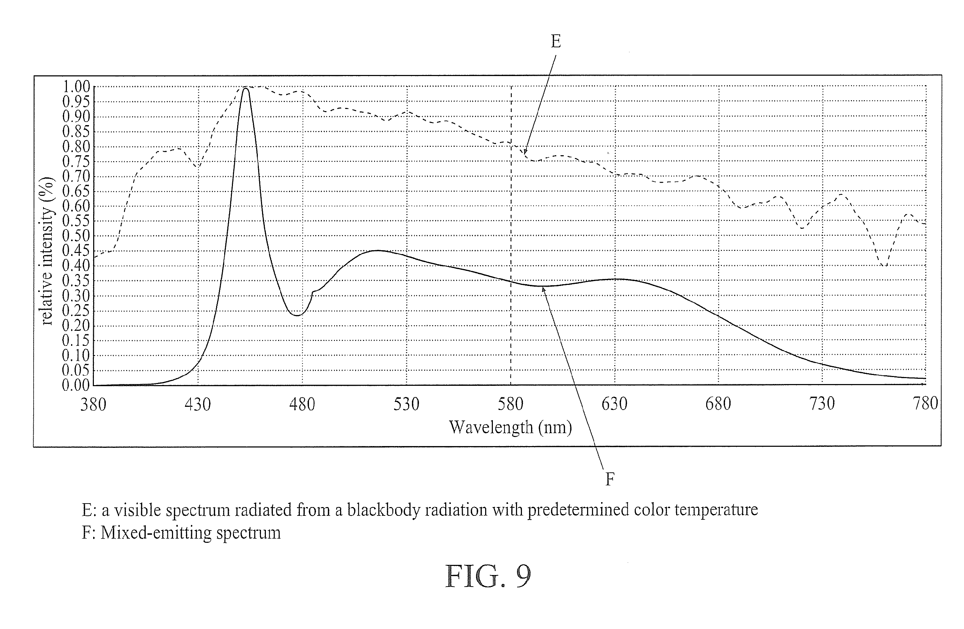

A spectrum comparison unit (74) determines the similarity between the mixed-emitting spectrum and the visible spectrum radiated from a blackbody with a predetermined color temperature as shown in FIG. 9. Curve E represents the visible spectrum radiated from a blackbody with a predetermined color temperature, and Curve F represents the mixed-emitting spectrum. The similarity is determined by overlapping the curves. If the outcome of the similarity comparison indicates "yes," a proper white light emission spectrum is generated. If the outcome indicates "no," the proportional relation of the fluorescent powder (76) shall be adjusted or the fluorescent powder shall be reselected (77) until the similarity comparison indicates a "yes."

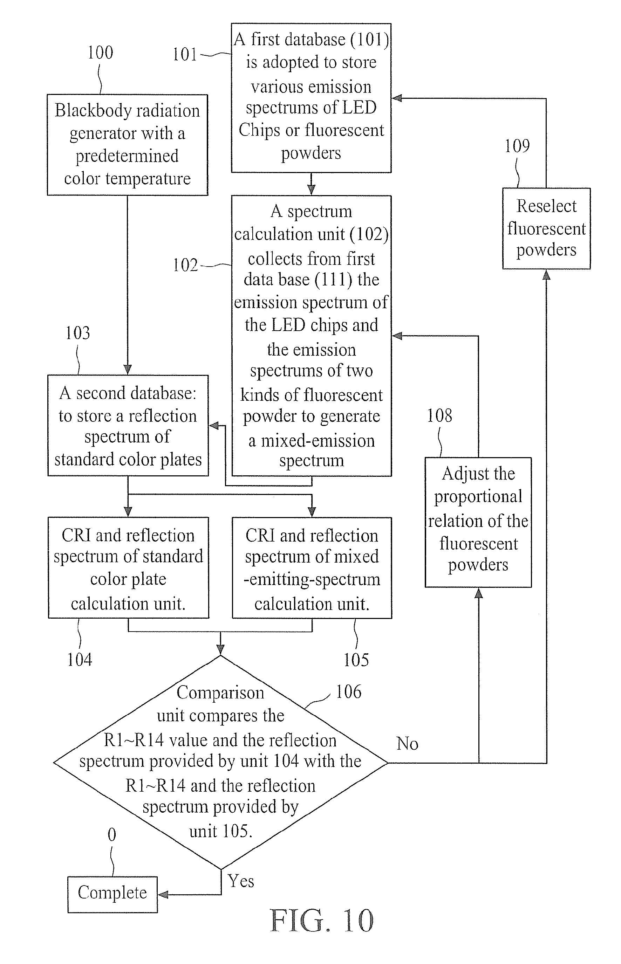

The present invention further discloses a block diagram for configuring a white light LED with high CRI as shown in FIG. 10. A blackbody radiation generator (100) with a predetermined color temperature provides a visible spectrum radiated from a blackbody with a predetermined color temperature. The color temperature ranges from 1500K to 8000K. A first database (101) is adopted to store various emission spectrums of LED chips or fluorescent powders. The emission range of an LED with UVA light is 365nm - 380nm, while the emission range of an LED with violet light is 380nm - 420nm and the emission range of an LED with blue light is 420nm - 470nm. The wavelength of an emission generated by a fluorescent powder is between 480nm and 580nm. The fluorescent powder can be a composition of compounds with silicates or oxides thereof, such as:

$CaSc_2O_4$:Ce(516nm),

$(MgCaSrBa)_2SiO_4$:Eu (525nm),

$Ca_3Sc_2Si_3O_{12}$:Ce(455-507nm),

$(Ca_{1.47}Mg)_{1.5}Ce_{0.03})(Sc_{1.5}Y_{0.5})Si_3Ol_2$(455nm),or

$(Ca_{2.97}Ce_{0.03})Sc_2(Si,Ge)_3O_{12}$.

The fluorescent powder can be a composition of compounds with nitrides or with sulfides having emission wavelength between 600nm and 650nm such as:

$CaAlSiN_3$:Eu(650nm),

$(CaEu)AlSiN_3$(648nm),

$(SrCa)AlSiN_3$:Eu(630nm), or

$SrGa_2S_4$:Eu(645nm).

Those skilled in the art may utilize other kinds of fluorescent powder to implement present invention such as a compound with garnetite or with nitrogen oxides.

A spectrum calculation unit (102) collects from the first database (111) the emission spectrum of the LED chips and the emission spectrums of two kinds of fluorescent powder. A blackbody radiation generator (100) with a predetermined color temperature generates a visible spectrum radiated from a blackbody with a predetermined color temperature. The proportional relation of the fluorescent powder may be adjusted based on the comparison of the visible spectrums with the emission spectrums collected. The spectrum calculation unit (102) thus generates a mixed-emitting spectrum.

A second database (103) is adopted to store reflection spectrums of standard color plates. Based on the information stored in the second database (103) and visible spectrums radiated from a blackbody with a predetermined color temperature, the CRI and reflection spectrum of standard color plate calculation unit (104) calculates and provides the reflection spectrums and the CRI (R1 - R14) of 14 color plates emitted by visible spectrums radiated from a blackbody with a predetermined color temperature.

Based on the information stored in the second database (103) and the mixed-emitting spectrums calculated by unit 102, the CRI and reflection spectrum of mixed color spectrum calculation unit (105) calculates the CRI values (R1 - R14) and the reflection spectrum of the 14 color plates emitted by the mixed-emitting spectrums.

A comparison unit (106) compares the R1 - R14 value and reflection spectrums provided by unit 104 with the R1 - R14 and reflection spectrums provided by unit 105. Unit 106 thus identifies the lowest CRI value among R1 - R14 identified and generates the average CRI value (Ra). If R1 - R14 and Ra meet a predetermined value, a proper white light emission spectrum is generated. If one of the values R1 - R14 and Ra does not meet the predetermined value (No), the proportional relation of the fluorescent powders is adjusted (108), or the fluorescent powders are reselected (109) until the predetermined value is met.

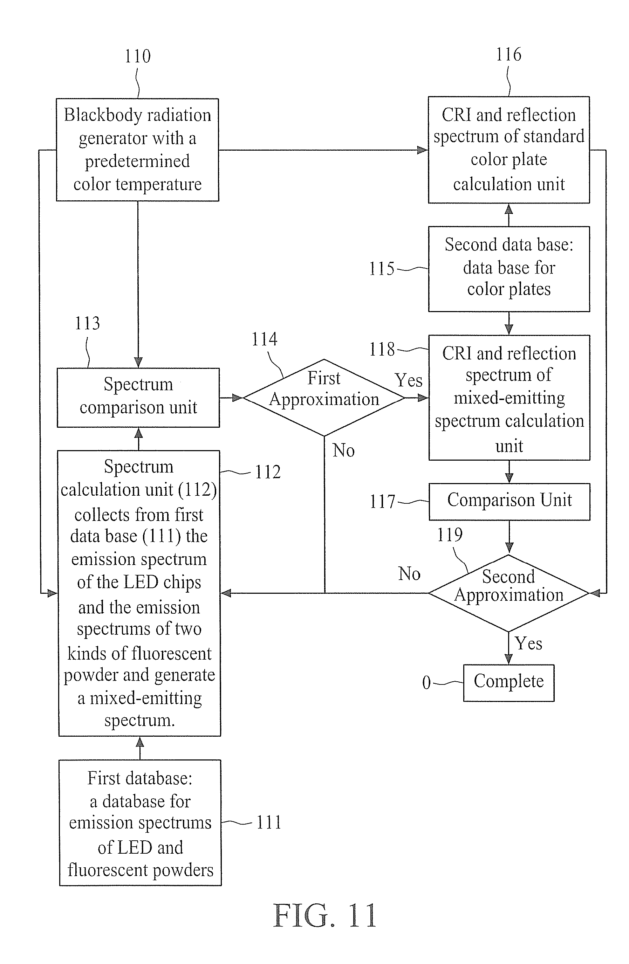

FIG. 11 discloses a system diagram for configuring a white light LED with high CRI. A blackbody radiation generator (110) with a predetermined color temperature generates a visible spectrum radiated from a blackbody with a predetermined color temperature. The color temperature ranges from 1500K to 8000K.

A first database (111) is adopted to store various emission spectrums of LED Chips or fluorescent powders. The emission range of an LED with UVA light is 365nm - 380nm, while the emission range of an LED with violet light is 380nm - 420nm and the emission range of an LED with blue light is 420nm - 470nm. The wavelength of an emission generated by a fluorescent powder is between 480nm and 580nm. The fluorescent powder can be a composition of compounds with silicates or oxides thereof, such as:

$CaSc_2O_4$:Ce(516nm),

$(MgCaSrBa)_2SiO_4$:Eu (525nm),

$Ca_3Sc_2Si_3O_{12}$:Ce(455-507nm),

$(Ca_{1.47}Mg_{1.5}Ce_{0.03})(SC_{1.5}Y_{0.5}Si_3Ol_2$(455nm),or

$(Ca_{2.97}Ce_{0.03})Sc_2(Si,Ge)_3)O_{12}$.

The fluorescent powder can be a composition of compounds with nitrides or with sulfides, and its emission wavelength is between 600nm and 650nm such as:

$CaAlSiN_3$:Eu(650nm),

$(CaEu)AlSiN_3$(648nm),

(SrCa)AlSiN$_3$:Eu(630nm), or

SrGa$_2$S$_4$:Eu(645nm).

Those skilled in the art may utilize other kinds of fluorescent powder to implement the present invention such as a compound with garnetite or with nitrogen oxides.

A spectrum calculation unit (112) collects from the first database (111) the emission spectrum of the LED chips and the emission spectrums of two kinds of fluorescent powder. The proportional relation of the fluorescent powders may be thus determined and adjusted. The spectrum calculation unit (112) then generates a mixed-emitting spectrum.

The spectrum comparison unit (113) determines the similarity by comparing the mixed-emitting spectrum with the visible spectrum radiated from a blackbody with a predetermined color temperature. The outcome of the comparison is the first approximation (114). If the first approximation indicates Yes, the process moves on. If the first approximation indicates No, the process returns to the spectrum calculation unit 112 and reselects proportional relations of other fluorescent powders until the first approximation indicates Yes.

The second database (115) stores reflection spectrums of 14 standard color plates. Based on the information stored in the second database (115) and the blackbody radiation generator (110) with a predetermined color temperature, the CRI and reflection spectrum of standard color plate calculation unit (116) calculates and provides the reflection spectrums and 14 CRI values (R1 - R14) of 14 color plates emitted by visible spectrums of a blackbody with a predetermined color temperature .

Based on the mixed-emitting spectrum and the information stored in the second database(115), the CRI and reflection spectrum of mixed-emitting spectrum calculation unit (118) calculates and provides the 14 CRI values (R1 - R14) and the reflection spectrum of the 14 color plates when emitted by the mixed-emitting spectrum.

Comparison unit 117 compares the outcomes provided by unit 116 and unit 118. Unit 117 identifies the lowest CRI value among R1 - R14 and generates the average value (Ra) for a comparison. The outcome of the comparison is the second approximation (119). If R1 - R14 and Ra meet a predetermined value (Yes), a high-level approximation is achieved. If one of the values R1 - R14 and Ra does not meet the predetermined value (No), the procedure returns to 112 to adjust the proportional relation of the fluorescent powders or to reselect the fluorescent powders.

The embodiment utilizes a mixture of two fluorescent powders. Three kind of fluorescent powders may be used as well. When necessary, more than three kind of fluorescent powders may be used.

The measurement of the present invention is to determine the spectrum radiated from a blackbody with a predetermined temperature by Planck's formula. Based on the spectrum determined, the first approximation proportional relations of multiple fluorescent powders may be calculated. Based on the first approximation proportional relation, the spectrum of the mixed-emitting LED is calculated, and the CRI of a standard color plate may be accordingly calculated and determined. Based on the color plate with the lowest CRI, the proportional relation of each fluorescent powder may be adjusted to produce an LED with an optimized CRI.

The method of the present invention may therefore configure an LED with high CRI efficiently and reduce the time consumed for trial and error.

The present invention has several advantages in reducing the developing time when multiple fluorescent powders are used and in calculating the proportionality relation between the fluorescent powders more efficiently.

The embodiments of the present invention are intended to be illustrative only. Those skilled in the art may devise numerous alternative embodiments without departing from the scope of the following claims. Accordingly, the scope of the present invention shall be not limited to embodiments disclosed but shall be properly determined by the claims set forth below.

**Claims**

1. Method for configuring high CRI LED, comprising:

    calculating a standard spectrum, wherein the standard spectrum is a visible spectrum radiated from a blackbody with a first color temperature;
    providing an emission spectrum of an LED; an emission spectrum of a first fluorescent powder, and an emission spectrum of a second fluorescent powder; and
    adjusting the first fluorescent powder and the second fluorescent powder based on the standard spectrum to generate a first mixed-emitting spectrum.

2. Method of Claim 1, wherein the standard spectrum is calculated based on Planck's Formula.

3. Method of Claim 2, wherein the first mixed-emitting spectrum is generated by stimulating the LED, the first fluorescent powder, and the second fluorescent powder.

4. Method of Claim 3, further comprising:

  calculating the CRI of the first mixed-emitting spectrum in standard color plates; and
  determining a standard color plate with the lowest CRI, and adjusting the first fluorescent powder and the second fluorescent powder to generate a second mixed-emitting spectrum.

5. Method of Claim 1, wherein the first fluorescent powder is $CaSc_2O_4$:Ce, $(MgCaSrBa)_2SiO_4$:Eu, $Ca_3Sc_2Si_3O_{12}$:Ce, $(Ca_{1.47}Mg_{1.5}Ce_{0.03})(SC_{1.5}Y_{0.5})Si_3Ol_2$, or $(Ca_{2.97}Ce_{0.03})Sc_2(Si,Ge)_3)O_{12}$.

6. Method of Claim 5, wherein the second fluorescent powder is $CaAlSiN_3$:Eu, $(CaEu)AlSiN_3$, $(SrCa)AlSiN_3$:Eu, or $SrGa_2S_4$:Eu.

7. Method of Claim 1, further comprising a third fluorescent powder and an emission spectrum of the third fluorescent powder.

8. System for configuring high CRI LED, comprising:

  a first database to store an emission spectrum of an LED, an emission spectrum of a first fluorescent powder, and an emission spectrum of a second fluorescent powder;
  a second database to store a reflection spectrum of standard color plates;
  a blending unit to calculate a mixed-emitting spectrum of the LED, the first fluorescent powder, and the second fluorescent powder stored in the first database, wherein the mixed-emitting spectrum is a first mixed-emitting spectrum;
  a standard color temperature spectrum generator to generate a visible spectrum radiated from a blackbody with a first color temperature; and
  a spectrum comparison unit to compare the first mixed-emitting spectrum with the standard spectrum generated by the standard color temperature spectrum generator;
  a reflection spectrum generating unit of a standard color plate to read the reflection spectrum of standard color plates stored in the second database, and to generate standard color plate reflection spectrums of the first mixed-emitting spectrum and standard color plate reflection spectrums of the standard spectrum; and
  a color plate spectrum comparison unit to compare the standard color plate reflection spectrums of the first mixed-emitting spectrum with the standard color plate reflection spectrums of the standard spectrum.

9. System of Claim 8, wherein the standard spectrum is calculated based on Planck's Formula.

10. System of Claim 8, wherein the first mixed-emitting spectrum is generated by stimulating the LED, the first fluorescent powder, and the second fluorescent powder.

11. System of Claim 10, wherein the first fluorescent powder is $CaSc_2O_4$:Ce, $(MgCaSrBa)_2SiO_4$:Eu, $Ca_3Sc_2Si_3O_{12}$:Ce, $(Ca_{1.47}Mg_{1.5}Ce_{0.03})(SC_{1.5}Y_{0.5})Si_3Ol_2$, or $(Ca_{2.97}Ce_{0.03})SC_2(Si,Ge)_3)O_{12}$.

12. System of Claim 11, wherein the first fluorescent powder is $CaAlSiN_3$:Eu, $(CaEu)AlSiN_3$, $(SrCa)AlSiN_3$:Eu, or $SrGa_2S_4$:Eu.

13. System or method of Claim 8, further comprising a third fluorescent powder and an emission spectrum of the third fluorescent powder.

14. Method of calculating proportional relations of multiple fluorescent powders for configuring high CRI LED, comprising:

  adjusting proportional relations of multiple fluorescent powders such that a spectrum of an LED after mixed-emitting is similar to a spectrum radiated from a blackbody with a first color temperature; and
  determining a color plate with the lowest CRI among reflection spectrums of standard color plates, and adjusting the proportional relations of multiple fluorescent powders.

15. Method of Claim 14, wherein the material of one of the fluorescent powders is $CaSc_2O_4{:}Ce$, $(MgCaSrBa)_2SiO_4{:}Eu$, $Ca_3Sc_2Si_3O_{12}{:}Ce$, $(Ca_{1.47}Mg_{1.5}Ce_{0.03})(Sc_{1.5}Y_{0.5}Si_3Ol_2$, or $(Ca_{2.97}Ce_{0.03})Sc_2(Si,Ge)_3)O_{12}$.

FIG. 1

Extract from the chromaticity diagram
showing the Planckian curve

FIG. 2

31 — Adjust the proportional relations of multiple fluorescent powders such that a spectrum of the mixed-emitting of a LED is similar to a spectrum radiated from a blackbody radiation with a first color temperature.

32 — Adjust the proportional relations of various fluorescent powders by identifying the reflection spectrum of a color plate with the lowest CRI when the plates are illuminated by the mixed-emitting spectrums.

## FIG. 3

Calculate a standard spectrum

41

Provide a emission spectrum of a LED, a emission spectrum of a first fluorescent powder, and a emission spectrum of a second fluorescent powder

42

43 — Adjust the proportional relation of first fluorescent powder and the second fluorescent powder based on the standard spectrum to generate a first mixed-emitting spectrum similar to the standard spectrum

44 — Calculate the CRI of the first mixed-emitting spectrum in standard color plates

45 — Determine a standard color plate with the lowest CRI and to adjust the proportional relation of the first fluorescent powder and the second fluorescent powder to generate a second mixed-emitting spectrum

FIG. 4

51 — First Data Base

Second Data Base — 55

52 — Blending Unit

Reflection spectrum generating unit of a standard color plate — 56

54 — spectrum comparison unit

color plate spectrum comparison unit — 57

53 — Standard-color -temperature-spectrum generator

FIG. 5

```
┌─────────────────────────┐
│ Provide a emission       │
│ spectrum of LED, a       │
│ emission spectrum of the │
│ first fluorescent emission│──── 62
│ spectrum, and a emission │
│ spectrum of the second   │
│ fluorescent              │
└─────────────────────────┘
```

Based on Planck's formula to calculate a visible spectrum radiated from a blackbody with a predetermined color temperature — 61

Calculate a mixed-emission spectrum of the LED chips, the first fluorescent powder, and the second fluorescent powder — 63

Calculate the CRI and the reflection spectrum of the first mixed-emitting spectrum emitted onto standard color plates — 64

Determine the lowest CRI values (R1~R14) of standard color plates, adjust the proportional relations between the first fluorescent powder and the second fluorescent powder, and generate second mixed-emitting spectrum. — 65

FIG. 6

FIG. 7

FIG. 8

A: Emission spectrum of LED Chips
B: Emission spectrum of first fluorescent powder
C: Emission spectrum of second fluorescent powder
D: Mixed-emitting spectrum

EP 2 164 301 A2

E: a visible spectrum radiated from a blackbody radiation with predetermined color temperature
F: Mixed-emitting spectrum

FIG. 9

100

101 — A first database (101) is adopted to store various emission spectrums of LED Chips or fluorescent powders

109

Reselect fluorescent powders

Blackbody radiation generator with a predetermined color temperature

102 — A spectrum calculation unit (102) collects from first data base (111) the emission spectrum of the LED chips and the emission spectrums of two kinds of fluorescent powder to generate a mixed-emission spectrum

108

103

A second database: to store a reflection spectrum of standard color plates

Adjust the proportional relation of the fluorescent powders

CRI and reflection spectrum of standard color plate calculation unit.

CRI and reflection spectrum of mixed -emitting-spectrum calculation unit.

104

105

Comparison unit compares the R1~R14 value and the reflection spectrum provided by unit 104 with the R1~R14 and the reflection spectrum provided by unit 105. — 106

No

0

Yes

Complete

# FIG. 10

110

Blackbody radiation generator with a predetermined color temperature

116

CRI and reflection spectrum of standard color plate calculation unit

115 — Second data base: data base for color plates

113

Spectrum comparison unit

114 First Approximation — Yes

118 — CRI and reflection spectrum of mixed-emitting spectrum calculation unit

No

112 Spectrum calculation unit (112) collects from first data base (111) the emission spectrum of the LED chips and the emission spectrums of two kinds of fluorescent powder and generate a mixed-emitting spectrum.

117 — Comparison Unit

119 Second Approximation

No

Yes

0 — Complete

First database: a database for emission spectrums of LED and fluorescent powders — 111

FIG. 11

**EP 2 164 301 A2**

## REFERENCES CITED IN THE DESCRIPTION

**Patent documents cited in the description**

- US 20070194695 A1

- TW 1263360